# FASCICULE DE BREVET EUROPEEN

(11) **EP 2 931 608 B1**
(45) Date de publication et mention de la délivrance du brevet: **06.04.2016**
(21) Numéro de dépôt: 13817663.1
(22) Date de dépôt: 11.12.2013
(51) Int. Cl.: B64D 31/00, H03K 19/007

(54) **CIRCUIT ELECTRIQUE REDONDE DE COUPURE DE L'ALIMENTATION ELECTRIQUE D'UN EQUIPEMENT**
REDUNDANTE ELEKTRISCHE SCHALTUNG ZUM ABSCHNEIDEN DER STROMVERSORGUNG EINES AUSSTATTUNGSTEILS
REDUNDANT ELECTRIC CIRCUIT FOR CUTTING OFF THE POWER SUPPLY TO A PIECE OF EQUIPMENT

(30) Priorité: 11.12.2012 FR 1261900
(43) Date de publication de la demande: 21.10.2015
(73) Titulaire: SAGEM Défense Sécurité, 92100 Boulogne Billancourt (FR)
(72) Inventeur: COURTEILLE, Jean-Marie, F-92100 Boulogne-Billancourt (FR); VALETTE, Patrick, F-92100 Boulogne-Billancourt (FR); GUILLOT, François, F-92100 Boulogne-Billancourt (FR); SCHINDLER, Sonia, F-92100 Boulogne-Billancourt (FR)
(74) Mandataire: Regimbeau
(86) Numéro de dépôt international: PCT/EP2013/076170
(87) Numéro de publication internationale: WO 2014/090849

(56) Documents cités:
- EP-A2- 1 286 266
- DE-A1- 19 857 396
- US-A- 4 868 826

## Description

### DOMAINE TECHNIQUE GENERAL

L'invention concerne le domaine de la sécurité de la commande de systèmes ou d'équipements, notamment électroniques et particulièrement ceux embarqués à bord d'un aéronef.

### ETAT DE LA TECHNIQUE

Un système électrique peut être commandé après qu'une condition est vérifiée.

Une solution connue est de connecter l'alimentation du système électrique à un circuit électrique configuré pour tester des signaux discrets indiquant que la condition est vérifiée.

Par exemple, dans le cas d'un aéronef, certains équipements électriques doivent être coupés en vol, par exemple dans le cas d'un système d'acquisition, de traitement et de communication de données avioniques, le module radio de transmission sans fil doit être coupé pour ne pas perturber le fonctionnement de l'aéronef.

Au moyen de portes logiques ET (en anglais, « AND ») connectées à des interrupteurs il est possible simplement de couper l'alimentation du module radio si nécessaire.

Une telle solution n'est toutefois pas satisfaisante lorsque des niveaux de fiabilité (en anglais, « *safety* ») particulièrement élevés sont requis. Par exemple, les niveaux de fiabilité requis pour l'alimentation des équipements électriques présentant un risque catastrophique, c'est-à-dire menant potentiellement à la perte de vies humaines sont de l'ordre de 10⁻⁹ par heure de vol.

### PRESENTATION DE L'INVENTION

L'invention propose de pallier au moins un de ces inconvénients.

A cet effet, l'invention propose un circuit électrique adapté pour commander une alimentation électrique d'un équipement électrique selon la revendication 1.

L'invention est avantageusement complétée par les caractéristiques suivantes, prises seules ou en une quelconque de leur combinaison techniquement possible :
- les branches parallèles du module de comparaison redondée des signaux discrets d'entrée réalisent une comparaison desdits signaux par la mise en oeuvre respectivement d'une logique positive et d'une logique négative.
- Le circuit électrique comprend en outre un premier module de vérification de la tension d'alimentation dudit circuit.
- Le circuit électrique comprend en outre un module de comparaison des signaux de commande et des signaux discrets de chaque branche.
- Le circuit électrique comprend en outre un second module de vérification des sorties du module de comparaison et du premier module de vérification de la tension et de comparaison des signaux de commandes et des signaux discrets, ledit second module de vérification ayant en sortie une variable discrète de synthèse.
- le circuit a pour entrées trois signaux électriques discrets.

L'invention propose également un système d'acquisition, de traitement et de communication de données avioniques embarqué dans un aéronef, comprenant un circuit électrique selon l'invention, dans lequel l'équipement électrique est un module de communication à distance de données avioniques, et les signaux électriques discrets d'entrée sont des signaux relatifs à l'état dudit aéronef,

le circuit électrique étant adapté pour alimenter électriquement le module de communication à distance de données avioniques lorsque toutes les signaux électriques d'entrée indiquent un état à l'arrêt et au sol dudit aéronef.

Avantageusement, mais facultativement, le système selon l'invention peut aussi présenter les caractéristiques suivantes : le circuit électrique comprend en outre un module d'acquisition centralisée d'au moins l'une des données parmi le groupe suivant :
- valeurs des signaux de commande issus du module de comparaison,
- valeur discrète de synthèse,
- état des interrupteurs,
- état du signal d'entrée de l'équipement de communication à distance des données avioniques,
- état de fonctionnement de l'équipement de communication à distance,
le système comprenant en outre un dispositif de signalisation des données acquises par le module d'acquisition centralisée.

On a donc proposé un circuit électrique présentant plusieurs niveaux de redondances : sont ainsi redondées
- les comparaisons des signaux électriques discrets d'entrée,
- les signaux de commande issus desdites comparaison, et
- les commandes de coupure de l'alimentation électrique de l'équipement de transmission à distance des données.

Ces multiples redondances permettent de minimiser l'impact de la défaillance d'un composant électronique individuel, et de diminuer la probabilité que l'équipement électrique soit alimenté alors qu'il ne doit pas l'être à moins de 10⁻⁹ par heure de vol.

En outre, un module de coupure de l'alimentation électrique garantit qu'une défaillance d'un composant électronique n'engendre pas d'alimentation non désirée de l'alimentation électrique.

### PRESENTATION DES FIGURES

D'autres caractéristiques, buts et avantages de l'invention ressortiront de la description qui suit, qui est purement illustrative et non limitative, et qui doit être lue en regard des dessins annexés sur lesquels :
- La figure 1 représente un système d'acquisition, de traitement et de communication de données avioniques conforme à un mode de réalisation de l'invention.
- La figure 2 illustre un schéma de principe d'un circuit électrique conforme à un mode de réalisation de l'invention.

### DESCRIPTION DETAILLEE D'UN MODE DE REALISATION DE L'INVENTION

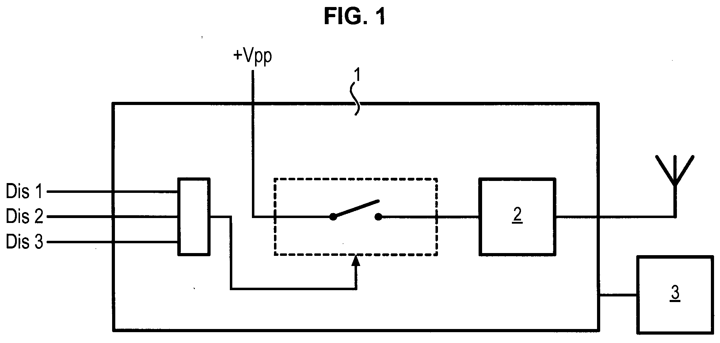

En relation avec la figure 1, un système d'acquisition, de traitement et de communication de données avioniques comprend :
- une unité d'acquisition (non représentée) de signaux électriques discrets DIS1 DIS2, DIS3 indiquant un état de l'aéronef ;
- un circuit électrique 1 comprenant :
   ∘ un module 2 radio adapté pour transférer les données avioniques du système vers une station distante ;
   ∘ une source de tension +Vpp d'alimentation du module 2 radio,
   le circuit électrique étant adapté pour commander de l'alimentation électrique du module 2, en coupant l'alimentation du module radio lorsque l'aéronef est en vol, et
- un dispositif de signalisation 3 d'informations relatives au circuit électrique 1 et aux données avioniques à communiquer. Cette signalisation pouvant être un afficheur, une imprimante ou tout autre moyen de communication à un système avionique externe.

Un état de l'aéronef est par exemple en vol, au sol, etc. Lorsque l'aéronef est au sol des signaux électriques discrets indiquant que l'aéronef est à l'arrêt sont par exemple : un signal indiquant l'existence d'un poids de l'aéronef sur les roues, un signal indiquant que les moteurs de l'aéronef sont à l'arrêt, ou bien un signal indiquant que les portes de l'aéronef sont ouvertes, etc.

Le circuit électrique d'alimentation peut être modélisé par un interrupteur commandé par une fonction logique des signaux électriques discrets (voir la figure 1).

On précise que l'on entend par fonction logique une série d'opérations logiques à une ou plusieurs variables. Des fonctions logiques connues sont : ET (en anglais, « AND »), OU (en anglais « OR »), OU exclusif (en anglais, « XOR »), etc.

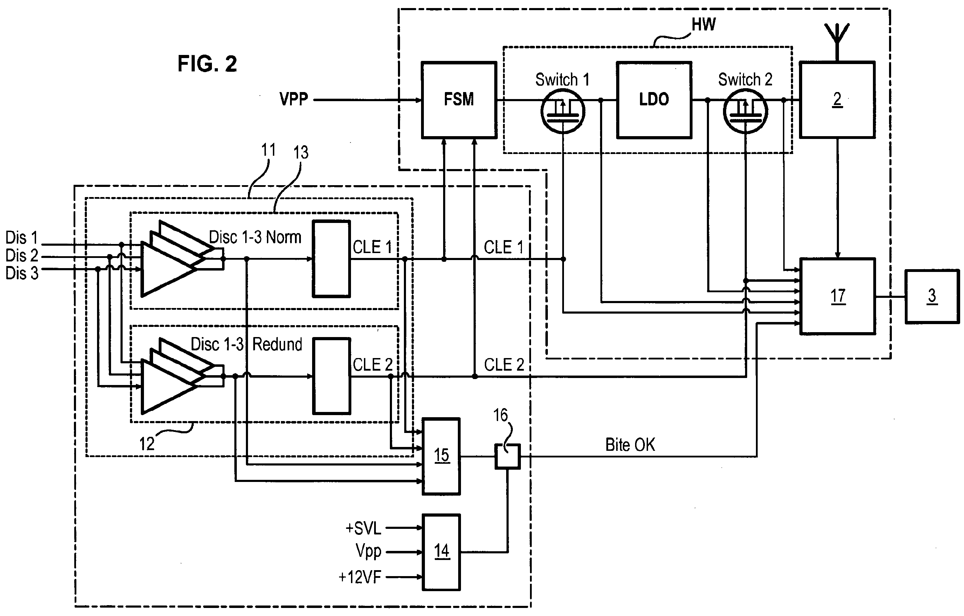

En relation avec la figure 2, le circuit électrique 1 reçoit en entrée au moins deux signaux électriques discrets, de préférence trois signaux électriques discrets DIS1, DIS2, DIS3, ou plus, et comprend une source de tension + Vpp. Les valeurs des signaux électriques discrets conditionnent l'alimentation électrique du module 2 radio.

En l'occurrence, pour que le module radio 2 soit alimenté, les signaux électriques discrets DIS1, DIS2, DIS3 doivent tous être égaux entre eux, leur valeur logique, 1 ou 0, devant correspondre pour chaque signal électrique discret à un état au sol de l'aéronef selon la convention choisie.

Bien entendu, on peut envisager un circuit électrique recevant en entrée un nombre plus élevé de signaux électriques discrets.

A titre d'exemple non limitatif, on considère dans la suite que les signaux électriques discrets doivent tous les trois être égaux à 1 pour que l'équipement électrique soit alimenté.

Comme cela est décrit dans ce qui suit, si un seul composant est utilisé pour tester les valeurs des signaux électriques discrets, celui-ci présente une probabilité de défaillance qui n'est pas négligeable, de sorte que l'équipement électrique a une probabilité non négligeable d'être alimenté alors qu'il ne devrait pas l'être.

Pour pallier ce problème, le circuit électrique présente des comparaisons redondées des signaux électriques discrets, pour prévenir une défaillance d'un composant. Ceci permet de diminuer la probabilité d'alimenter l'équipement électrique alors qu'il ne devrait pas l'être.

En effet, la probabilité de défaillance du circuit doit être de l'ordre de 10⁻⁹ alors qu'un composant électronique seul à une probabilité de défaillance de l'ordre de 10⁻⁶.

Le circuit électrique 1 comprend un module 11 de comparaison redondée des signaux électriques discrets DIS1, DIS2, DIS3. Le module 11 de comparaison comprend deux branches de comparaison 12, 13 des signaux en parallèle, chaque branche comprenant une fonction logique prenant en entrée les signaux électriques discrets - c'est-à-dire faisant l'acquisition et l'adaptation d'une interface physique avec l'environnement externe, et adaptée pour fournir en sortie un signal de commande respectif CLE 1, CLE 2, représentatif de la comparaison desdits signaux électriques discrets en entrée.

A titre d'exemple, une branche de comparaison peut mettre en oeuvre la fonction logique ET entre les signaux électriques discrets, de sorte que le signal de commande en sortie vaut 1 uniquement si tous les signaux électriques discrets valent 1.

Avantageusement, mais non limitativement, les fonctions logiques mises en oeuvre par les deux branches de comparaison 12, 13 des signaux discrets sont distinctes, de façon à obtenir une comparaison par deux voies différentes.

Par exemple, la fonction logique d'une des branches met en oeuvre une logique positive, c'est-à-dire une comparaison des discrets eux-mêmes (élément DISC1-3 Norm sur la figure 2), et l'autre met en oeuvre une logique négative, c'est-à-dire une comparaison des inverses des discrets (élément DISC1-3 Redund sur la figure 2).

Comme on l'aura compris, le module 11 de comparaison permet donc de redonder la comparaison des signaux discrets.

Si les signaux de commande CLE 1, CLE 2 en sortie de chaque branche du module 11 de comparaison sont e égaux, par exemple égaux à 1 cela correspond à un fonctionnement normal, le cas contraire correspond à un dysfonctionnement dans une des branches du module 11 de comparaison.

Toujours en relation avec la figure 2, le circuit électrique 1 comprend un premier module de coupure HW de l'alimentation électrique de l'équipement 2, ce module étant commandé par les signaux de commande CLE 1 CLE 2 issus du module 11 de comparaison en amont.

Ce premier module de coupure HW comporte deux interrupteurs en série Switch1, Switch2, disposés entre l'alimentation Vpp et l'équipement électrique 2, chacun des deux interrupteurs étant commandé respectivement par l'un des deux signaux de commande CLE 1, CLE 2.

La premier module de coupure HW permet donc de redonder la commande issue des signaux de commande CLE 1, CLE 2. Pour que l'équipement électrique soit alimenté, les deux signaux de commande doivent être égaux et en particulier dans l'exemple présenté ci-avant, les signaux de commande CLE 1, CLE 2 doivent être égaux à 1 tous les deux.

Si, suite à un dysfonctionnement d'un composant électronique, les signaux de commande présentent des valeurs différentes, l'équipement électrique n'est cependant pas alimenté.

Par cette redondance de la commande issue de la comparaison des discrets, la défaillance d'un composant électronique risque moins de déclencher l'alimentation de l'équipement électrique 2. En d'autres termes, la probabilité que l'équipement électrique 2 soit alimenté alors qu'il ne doit pas l'être est réduite.

Comme cela est illustré sur la figure 2, le circuit électrique 1 comprend en outre un deuxième module de coupure FSM en anglais, « *FailSafe Monitoring »,* c'est-à-dire garantissant qu'un dysfonctionnement d'un composant électronique n'engendre pas de danger pour l'appareil, et qu'en l'occurrence un tel dysfonctionnement ne génère pas un risque d'alimentation de l'équipement électronique 2 alors qu'il ne devrait pas l'être.

Ce deuxième module de coupure FSM est connecté en série entre la source de tension d'alimentation Vpp de l'équipement électrique 2 et le premier module HW de coupure.

Le deuxième module de coupure FSM est notamment commandé par les deux signaux de commande CLE 1, CLE 2 issus du module 11 de comparaison des signaux discrets d'entrée.

Le deuxième module de coupure FSM est adapté pour n'autoriser l'alimentation de l'équipement électrique que dans le cas où les valeurs des deux signaux de commande CLE 1, CLE 2 sont égales et correspondent à des valeurs de l'ensemble des discrets correspondant à un état « au sol » de l'aéronef.

En reprenant l'exemple précédent, le deuxième module de coupure FSM n'autorise l'alimentation de l'équipement électrique que si les deux signaux de commande CLE 1, CLE 2 sont égaux à 1.

En outre, deuxième module de coupure FSM a également pour objectif de détecter un dysfonctionnement dans les composants du module 11 de comparaison des discrets. A cet égard, si les valeurs des signaux de commande diffèrent, le module isole l'équipement électrique de la source d'alimentation Vpp en générant un court-circuit. A cet égard, le module de coupure FSM peut détruire un organe d'isolation tel qu'un fusible ou un disjoncteur.

En conséquence, grâce aux premier et deuxième modules de coupure HW, FSM, la coupure de l'alimentation Vpp commandée par les signaux de commande CLE 1, CLE 2, est elle-même redondée, ce qui diminue la probabilité de défaillance du circuit électrique 1.

De manière complémentaire, le premier module de coupure HW peut comprendre un régulateur de tension LDO disposé entre le premier interrupteur Switch1 et le second interrupteur pour adapter la valeur de la tension en entrée du dispositif de signalisation 3.

Encore de manière complémentaire, le circuit électrique 1 est connecté à un dispositif de signalisation 3 d'informations relatives à l'état du circuit électrique et aux données avioniques.

A cet égard, le circuit électrique 1 comprend un module 15 de comparaison entre les valeurs redondées des signaux discrets d'entrée d'une part, et des signaux de commande CLE 1, CLE 2 d'autre part.

Ce module reçoit donc en entrée :
- les valeurs des discrets DISC1-3 Norm, DISC1-3 Redund dans les deux branches 12, 13 du module 11 de comparaison, qu'il compare deux à deux et
- les valeurs des signaux de commande CLE 1, CLE 2 issus de la comparaison des discrets qu'il compare deux à deux.

En sortie, il génère une information indiquant si les données comparées sont correctes, par exemple 1 si les informations redondées sont cohérentes entre elles, et 0 sinon.

Le circuit 1 comprend également un premier module 14 de vérification pour vérifier les valeurs des tensions dans le circuit. Il vérifie la valeur de la tension d'alimentation des modules 13 et 15, qui doit être par exemple à 5V, la valeur de la tension d'alimentation des interfaces d'acquisition des discrets dans les modules 12 et 13, qui doit être par exemple à 12 V, et la valeur de la tension d'alimentation Vpp de l'équipement électrique. Si l'une de ces tensions n'a pas la valeur attendue, les informations obtenues en sorties des modules 12, 13 et 15 pourraient être faussées.

Par exemple, les valeurs de signaux de commande CLE 1 et CLE2 pourraient être incorrectes si les tensions d'alimentation des modules 12 et 13 le sont.

Le module 14 de vérification des tensions génère en sortie un signal dont la valeur indique que les tensions du circuit sont conformes ou non à ce qu'elles devraient être. Par exemple, la sortie du module de vérification 14 est à 1 si toutes les tensions sont conformes à leur plage de valeur nominale attendue.

Ce module 14 de vérification peut également être utilisé pour inhiber les valeurs de signaux de commande CLE1 et CLE2 si les tensions ne sont pas conformes à leur plage de valeur nominale attendue.

Le circuit comprend enfin un second module 16 de vérification recevant en entrée la sortie du module de comparaison 15 d'une part et la sortir du premier module 14 de vérification et générant une variable BITE_OK de synthèse de ces informations. Le second module 16 de vérification est par exemple une fonction logique ET. Ainsi par exemple, les sorties du module de comparaison 15 et du premier module de comparaison 14 sont à 1, et la variable BITE_OK aussi.

Enfin, le circuit comprend également un module 17 d'acquisition centralisée des données relatives à l'état du circuit. Ces données comprennent tout ou partie des données suivantes :
- variable BITE_OK
- état des signaux de commande CLE 1, CLE 2,
- état des interrupteurs Switch1, Switch2 du premier module de coupure HW,
- état du régulateur de tension LDO, et
- état du signal en entrée de l'équipement de communication à distance 2, et
- état de fonctionnement de l'équipement de communication à distance 2.

Le module 17 d'acquisition centralisée communique lesdites données au dispositif de signalisation et d'affichage 3 qui affiche ces données, par exemple au moyen de diodes lumineuses, ou d'informations en clair sur des écrans de visualisation. Ceci permet à un opérateur de détecter immédiatement un dysfonctionnement à un niveau du circuit électrique. Le dysfonctionnement ainsi détecté peut être réparé plus tôt, et la probabilité que l'équipement 2 soit alimenté alors qu'il ne doit pas l'être est encore diminuée.

## Revendications

1. Circuit électrique (1) adapté pour commander une alimentation électrique (Vpp) d'un équipement électrique (2), le circuit (1) électrique comprenant un équipement électrique (2) et une source de tension d'alimentation (Vpp), et ayant en outre pour entrées au moins deux signaux électriques discrets (DIS 1, DIS 2, DIS 3) dont les valeurs conditionnent la coupure de l'alimentation électrique de l'équipement,
le circuit étant **caractérisé en ce qu'**il comprend en outre :
- un module de comparaison (11) redondée des signaux électriques discrets (DIS 1, DIS 2, DIS 3), comprenant deux branches (12, 13) de comparaison desdits signaux, en parallèle l'une de l'autre, chaque branche étant adaptée pour fournir en sortie un signal de commande (CLE 1, CLE 2) représentatif de chacune des comparaisons desdits signaux électriques discrets,
- un premier module de coupure (HW) de l'alimentation électrique de l'équipement électrique comprenant deux interrupteurs en série (Switch 1, Switch 2), chacun étant commandé respectivement par l'un des deux signaux de commande (CLE 1, CLE 2), et
- un second module (FSM) de coupure de l'alimentation électrique de l'équipement électrique connecté en série entre la source de tension d'alimentation (VPP) de l'équipement électrique et le premier module (HW) de coupure, et commandé par les deux signaux de commande (CLE 1, CLE 2) issus du module de comparaison (11) redondé.

2. Circuit électrique (1) selon la revendication précédente, dans lequel les branches parallèles (12, 13) du module de comparaison (11) redondée des signaux discrets d'entrée (DIS1, DIS2, DIS3) réalisent une comparaison desdits signaux par la mise en oeuvre respectivement d'une logique positive et d'une logique négative.

3. Circuit électrique (1) selon l'une des revendications précédentes, comprenant en outre un premier module (14) de vérification de la tension d'alimentation (Vpp) dudit circuit (1).

4. Circuit électrique (1) selon l'une des revendications précédentes, comprenant en outre un module (15) de comparaison des signaux de commande (CLE 1, CLE 2) et des signaux discrets (DISC1-3 Norm, DISC 1-3 Redund) de chaque branche (12, 13).

5. Circuit électrique selon les revendications 3 et 4, comprenant en outre un second module (16) de vérification des sorties du module de comparaison (15) et du premier module de vérification (14) de la tension et de comparaison des signaux de commandes et des signaux discrets, ledit second module de vérification (16) ayant en sortie une variable discrète de synthèse (BITE_OK).

6. Circuit électrique (10) selon l'une des revendications précédentes, ledit circuit ayant pour entrées trois signaux électriques discrets (DIS1, DIS2, DIS3).

7. Système (10) d'acquisition, de traitement et de communication de données avioniques embarqué dans un aéronef, comprenant un circuit électrique (1) selon l'une des revendications précédentes, dans lequel l'équipement électrique (2) est un module de communication à distance de données avioniques, et les signaux électriques discrets d'entrée (DIS1, DIS2, DIS3) sont des signaux relatifs à l'état dudit aéronef,
le circuit électrique (1) étant adapté pour alimenter électriquement le module (2) de communication à distance de données avioniques lorsque toutes les signaux électriques d'entrée indiquent un état à l'arrêt et au sol dudit aéronef.

8. Système (10) selon la revendication précédente, dans lequel le circuit électrique (1) comprend en outre un module (17) d'acquisition centralisée d'au moins l'une des données parmi le groupe suivant :
- valeurs des signaux de commande (CLE 1, CLE 2) issus du module de comparaison,
- valeur discrète de synthèse (BITE_OK)
- état des interrupteurs (Switch 1, Switch 2)
- état du signal d'entrée de l'équipement (2) de communication à distance des données avioniques,
- état de fonctionnement de l'équipement (2) de communication à distance, le système comprenant en outre un dispositif de signalisation (3) des données acquises par le module d'acquisition centralisée.

## Patentansprüche

1. Elektrische Schaltung (1), die zum Steuern einer elektrischen Versorgung (Vpp) eines elektrischen Ausstattungsteils (2) ausgebildet ist, wobei die elektrische Schaltung (1) ein elektrisches Ausstattungsteil (2) und eine Versorgungsspannungsquelle (Vpp) umfasst und ferner als Eingänge mindestens zwei diskrete elektrische Signale (DIS 1, DIS 2, DIS 3) hat, deren Werte die Unterbrechung der elektrischen Versorgung des Ausstattungsteils bedingen,
wobei die Schaltung **dadurch gekennzeichnet ist, dass** sie ferner umfasst:
- ein redundantes Vergleichsmodul (11) der diskreten elektrischen Signale (DIS 1, DIS 2, DIS 3), das zwei zueinander parallele Vergleichszweige (12, 13) der Signale umfasst, wobei jeder Zweig ausgebildet ist, um am Ausgang ein für jeden der Vergleiche der diskreten elektrischen Signale repräsentatives Steuersignal (CLE 1, CLE 2) bereitzustellen,
- ein erstes Unterbrechungsmodul (HW) der elektrischen Versorgung des elektrischen Ausstattungsteils, das zwei Schalter in Reihe (Switch 1, Switch 2) umfasst, wobei jeder von jeweils einem der zwei Steuersignale (CLE 1, CLE 2) gesteuert wird, und
- ein zweites Unterbrechungsmodul (FSM) der elektrischen Versorgung des elektrischen Ausstattungsteils, das zwischen der Versorgungsspannungsquelle (VPP) des elektrischen Ausstattungsteils und dem ersten Unterbrechungsmodul (HW) in Reihe geschaltet ist und von den zwei Steuersignalen (CLE 1, CLE 2) des redundanten Vergleichsmoduls (11) gesteuert wird.

2. Elektrische Schaltung (1) nach vorangehendem Anspruch, wobei die parallelen Zweige (12, 13) des redundanten Vergleichsmoduls (11) der diskreten Eingangssignale (DIS1, DIS2, DIS3) einen Vergleich der Signale durch die Umsetzung jeweils einer positiven Logik und einer negativen Logik durchführen.

3. Elektrische Schaltung (1) nach einem der vorangehenden Ansprüche, die ferner ein erstes Überprüfungsmodul (14) der Versorgungsspannung (Vpp) der Schaltung (1) umfasst.

4. Elektrische Schaltung (1) nach einem der vorangehenden Ansprüche, die ferner ein Vergleichsmodul (15) der Steuersignale (CLE 1, CLE 2) und der diskreten Signale (DISC1-3 Norm, DISC 1-3 Redund) jedes Zweigs (12, 13) umfasst.

5. Elektrische Schaltung nach einem der Ansprüche 3 und 4, die ferner ein zweites Überprüfungsmodul (16) der Ausgänge des Vergleichsmoduls (15) und des ersten Überprüfungsmoduls (14) der Spannung und des Vergleichs der Steuersignale und der diskreten Signale umfasst, wobei das zweite Überprüfungsmodul (16) am Ausgang eine diskrete Synthesevariable (BITE_OK) hat.

6. Elektrische Schaltung (10) nach einem der vorangehenden Ansprüche, wobei die Schaltung als Eingänge drei diskrete elektrische Signale (DIS1, DIS2, DIS3) hat.

7. On-Board-System (10) für die Erfassung, die Verarbeitung und die Kommunikation von Avionikdaten eines Luftfahrzeugs, das eine elektrische Schaltung (1) nach einem der vorangehenden Ansprüche umfasst, wobei das elektrische Ausstattungsteil (2) ein Fernkommunikationsmodul von Avionikdaten ist und die diskreten elektrischen Eingangssignale (DIS1, DIS2, DIS3) Signale sind, die sich auf den Zustand des Luftfahrzeugs beziehen,
wobei die elektrische Schaltung (1) ausgebildet ist, um das Fernkommunikationsmodul (2) von Avionikdaten elektrisch zu versorgen, wenn alle elektrischen Eingangssignale einen Haltezustand und am Boden des Luftfahrzeugs anzeigen.

8. System (10) nach vorangehendem Anspruch, wobei die elektrische Schaltung (1) ferner ein Modul (17) der zentralisierten Erfassung mindestens einer der Angaben aus der folgenden Gruppe umfasst:
- Werte der Steuersignale (CLE 1, CLE 2) des Vergleichsmoduls,
- diskreter Synthesewert (BITE_OK),
- Zustand der Schalter (Switch 1, Switch 2),
- Zustand des Eingangssignals des Fernkommunikationsausstattungsteils (2) der Avionikdaten,
- Funktionszustand des Fernkommunikationsausstattungsteils (2), wobei das System ferner eine Anzeigevorrichtung (3) der von dem Modul der zentralisierten Erfassung erfassten Daten umfasst.

## Claims

1. Electric circuit (1) adapted to controlling an electrical power supply (Vpp) of a piece of electrical equipment (2), the electric circuit (1) comprising electrical equipment (2) and a power supply voltage source (Vpp), and also having at least two discrete electrical signals (DIS 1, DIS 2, DIS 3) as inputs, which values control cutting off of the electrical power supply to the equipment,
the circuit being **characterised in that** it also comprises:
- a redundant comparison module (11) that compares discrete electrical signals (DIS 1, DIS 2, DIS 3), comprising two comparison branches (12, 13) of said signals in parallel with each other, each branch being adapted to provide an output control signal (CLE1, CLE2) representative of each of the comparisons of said discrete electrical signals, and,
- a first cut off module (HW) that cuts off the electrical power supply to the electrical equipment comprising two switches in series (Switch 1, Switch 2), each being controlled by one of the two control signals (CLE1, CLE2), and
- a second cut off module (FSM) to cut off the electrical power supply of the electrical equipment connected in series between the power supply voltage source (Vpp) of the electrical equipment and the first cut off module HW, and controlled by the two control signals (CLE1, CLE2) provided by the redundant comparison module (11).

2. Electrical circuit (1) according to the previous claim, in which the parallel branches (12, 13) of the redundant discrete input signals comparison module (11) make a comparison between said signals by the use of a positive logic and a negative logic respectively.

3. Electrical circuit (1) according to one of the previous claims, also comprising a first module (14) to verify the power supply voltage (Vpp) of said circuit (1).

4. Electrical circuit (1) according to one of the previous claims, also comprising a module (15) to compare control signals (CLE1, CLE2) and discrete signals (DISC1-3 Norm, DISC1-3 Redund) from each branch (12, 13).

5. Electrical circuit according to either claim 3 or 4, also comprising a second module (16) that verifies outputs from the comparison module (15) and the first module (14) that verifies the voltage and compares control signals and discrete signals, said second verification module (16) having a discrete synthetic variable (BITE_OK) as its output.

6. Electrical circuit (10) according to one of the previous claims, said circuit having three discrete electrical signals (DIS1, DIS2, DIS3) as input.

7. Avionics data acquisition, processing and communication system (10) onboard an aircraft, comprising an electric circuit (1) according to one of the previous claims, in which the electrical equipment (2) is an avionics data remote communication module and the discrete input signals (DIS1, DIS2, DIS3) are signals related to the state of said aircraft,
the electric circuit (1) being adapted to supply electrical power to the remote avionics data communication module (2) when all electric input signals indicate that said aircraft is stopped and is on the ground.

8. System (10) according to the previous claim, in which the electric circuit (1) also comprises a central module (17) for acquisition of at least one of the data among the following group:
- values of control signals CLE1, CLE2) output from the comparison module,
- discrete synthetic value (BITE_OK),
- state of switches (Switch1, Switch2),
- state of the input signal to the remote avionics data communication equipment (2),
- operating state of the remote communication
equipment (2),
the system also comprising a device (3) for signalling data acquired by the central acquisition module.
